(19) Europäisches Patentamt
European Patent Office
Office européen des brevets

(11) **EP 4 730 654 A1**

(12) **EUROPEAN PATENT APPLICATION**

(43) Date of publication:
**22.04.2026  Bulletin 2026/17**

(21) Application number: **24206830.2**

(22) Date of filing: **16.10.2024**

(51) International Patent Classification (IPC):
*H03M 1/06* (2006.01)     *H03F 3/45* (2006.01)
*H03K 5/24* (2006.01)     *H03M 1/12* (2006.01)
*H03M 1/46* (2006.01)     *H03M 1/80* (2006.01)

(52) Cooperative Patent Classification (CPC):
**H03M 1/1275; H03F 3/45183; H03K 5/2481;
H03K 5/249; H03M 1/0607; H03M 1/46;
H03M 1/804**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Imec VZW
3001 Leuven (BE)**

(72) Inventors:
• **Yang, Xiaolin
  3000 Leuven (BE)**
• **Xing, Xiaonan
  3001 Heverlee (BE)**
• **Sawigun, Chutham
  3001 Leuven (BE)**
• **Mora Lopez, Carolina
  3001 Heverlee (BE)**

(74) Representative: **Roth, Sebastian
  Mitscherlich PartmbB
  Karlstraße 7
  80333 München (DE)**

(54) **A REFERENCE-LESS LEVEL-CROSSING ADC WITH A BUMP-BASED ADAPTIVE-BIAS COMPARATOR**

(57)     This disclosure relates to a comparator circuit and an ADC circuit for a neural interface. The ADC circuit includes the comparator circuit. The comparator circuit comprises a comparator to receive a first and a second signal, and internally amplify the first and the second signal. A bump bias circuit of the comparator circuit receives the amplified first and second signal, and causes the comparator to operate at a higher power level when a difference between the amplified first and second signal is smaller, and at a lower power level when the difference between the amplified first and second signal is larger. The ADC circuit comprises two comparator circuits connected to a first and second switching circuit. A control circuit of the ADC circuit can set a capacitor state of first capacitor pairs of the first switching circuit, and a capacitor state of second capacitors pairs of the second switching circuit, based on outputs of the respective comparator circuit.

FIG. 1

EP 4 730 654 A1

**Description**

TECHNICAL FIELD

The present disclosure relates to comparators and analog-to-digital converters (ADCs), for example, suitable for a neural interface. A comparator circuit is presented, which includes a bump bias circuit. Further, a level-crossing (LC) based ADC circuit for a neural interface is presented, wherein the ADC circuit includes the comparator circuit having the bump bias circuit. Finally, a method of operating the comparator circuit is provided.

BACKGROUND

A large-scale neural interface is a system designed to facilitate extensive recordings from hundreds, or even thousands, of individual neurons simultaneously. This technology provides a means for neuroscience to better understand the inner workings of the brain.

An ADC is indispensable in such systems, and is used to periodically sample and convert neural signals for data transmission and post-processing. The ADC needs to have a sampling rate of tens of thousands of samples per second for each recording site. Hence, with increased recording density, data transmission or processing becomes a critical challenge. One promising approach is to facilitate a LC ADC, which converts a neural signal only when a specific neural event, such as a spike, happens. Unlike a traditional continuous-sampling ADC, which can generate massive amounts of data even when the neural activity is sparse, the LC ADC operates on a "sample-on-change" principle. It only records data when there is a meaningful change in the signal, hence, it reduces the overall data volume.

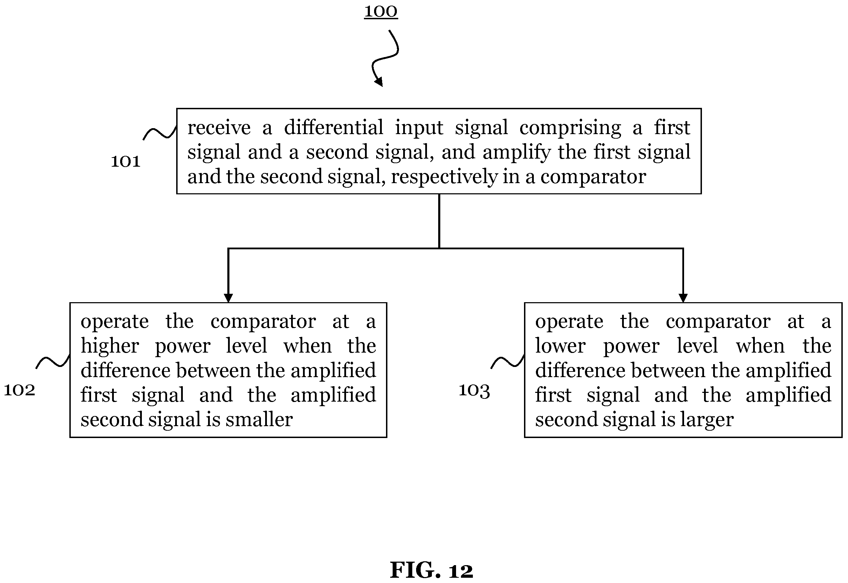

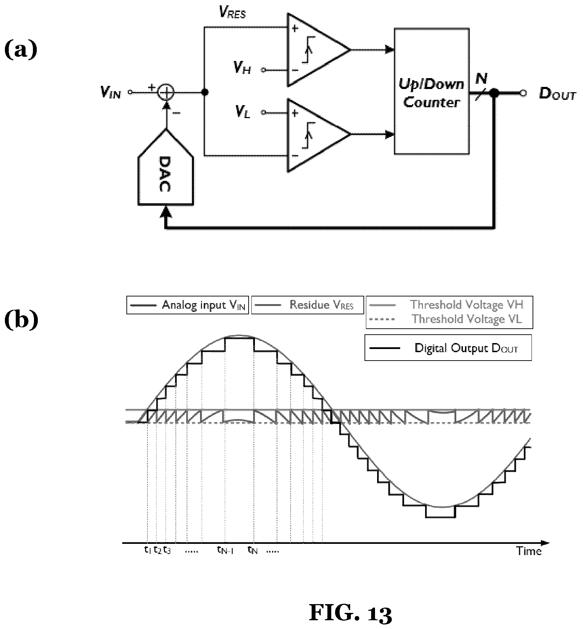

In particular, to achieve relatively low power consumption, a fixed-threshold-window LC ADC is conventionally used. As shown in Figure 12(a), such a LC ADC continuously tracks an input signal through a fixed threshold window, which is created by two voltages $V_H$ (high) and $V_L$ (low). An input representation of the quantized digital output Dour is fed back through a digital-to-analog converter (DAC), and subtracted from the analog input $V_{IN}$. The residue voltage $V_{RES}$ is the quantization error, which is then compared against two voltage thresholds $V_H$ and $V_L$ by upper or lower zero-crossing detectors (ZCD). When $V_{RES}$ exceeds this comparison interval, the corresponding ZCD triggers an update, and the up-down counter either increments or decrements, causing the DAC output to shift up or down by a voltage value $V_{th}$ (wherein it is assumed that $V_{th}$ is equal to $V_H$-$V_L$), so that the residue $V_{RES}$ is again maintained within the comparison interval (between $V_H$ and $V_L$). Therefore, the LC ADC generates a digital output only when a crossing or an event happens, which leads to a non-uniform sampling and conversion. FIG. 13(b) shows an example of a waveform (digital output $D_{OUT}$) of the LC ADC of FIG. 13(a) in comparison with the analog input $V_{IN}$.

The voltage thresholds created by $V_H$ and $V_L$ are crucial to the performance of the LC ADC. An extra voltage generator is, however, needed to generate these voltages. Moreover, a mismatch between $V_H$-$V_L$ and $V_{th}$ will degrade the performance of the LC ADC. An extra on-chip circuit or an off-chip fine trimmer may be used to generate the voltages $V_H$ or $V_L$ to eliminate this. However, both cause hardware complexity. Moreover, to continuously monitor the change of the residue voltage $V_{RES}$, the comparators should be always-on, so that the comparators consume a static bias current for a fast decision once a crossing happens. This results overall in high power consumption even if there is no event.

SUMMARY

In view of the above, an objective of this disclosure is to provide a comparator circuit with a low power consumption, in particular, when used in a LC ADC circuit for a neural interface. Further, another objective of this disclosure is to provide an ADC circuit for a neural interface, which is able to operate based on LC. The ADC circuit should require no additional voltage generators, and should be of lower hardware complexity than at least a conventional LC ADC for a neural interface.

These and other objectives are achieved by the solutions of this disclosure described in the independent claims. Advantageous implementations are described in the dependent claims.

A first aspect of this disclosure provides a comparator circuit comprising a comparator configured to receive a differential input signal comprising a first signal and a second signal, and configured to internally amplify the first signal and the second signal, respectively; a bump bias circuit configured to receive the amplified first signal and the amplified second signal; wherein the bump bias circuit is further configured to cause the comparator to operate at a higher power level when a difference between the amplified first signal and the amplified second signal is smaller, and operate at a lower power level when the difference between the amplified first signal and the amplified second signal is larger.

The comparator circuit of the first aspect can operate with a low power consumption. In particular, to achieve a reduced power consumption compared to a conventional comparator, the bump bias circuit is integrated with the comparator (may be a conventional comparator, except that it is connected to the bump bias circuit in the manner described). The bump bias circuit is used to monitor the amplified versions of the input signals, e.g. a differential voltage signal. When these signals of the differential input signal are closer together, the bump bias circuit will operate to set the comparator to the higher power mode. Conversely, when the input signals are less close together, i.e. more different from each other, the bump bias circuit tends to set the comparator into the lower power mode, which saves power. The current consumption is thus significantly lower than for a conventional constant bias comparator.

In an implementation of the comparator circuit, the bump bias circuit is configured to provide a larger supply current to the comparator when the difference between the amplified first signal and the amplified second signal is smaller; and provide a smaller supply current to the comparator when the difference between the amplified first signal and the amplified second signal is larger.

The bump bias circuit may comprise circuitry that receives the amplified first and second signal as input, and provides the supply current in dependence of the difference between the amplified first and second signal as output. This may be achieved with a variety of transistors and/or transistor pairs, as explained below, but is not limited to that example. For example, the supply current may be mirrored back through a current mirror to the comparator. The larger supply current maintains or transitions the comparator into the higher power mode, while the lower supply current maintains or transitions the comparator into the lower power mode, to significantly save power. In this disclosure, the comparator's power mode may accordingly depend on the supply current provided to the comparator.

In an implementation of the comparator circuit, the bump bias circuit is configured to provide a continuously increasing supply current to the comparator when a difference between the amplified first signal and the amplified second signal continuously decreases.

In an implementation of the comparator circuit, the bump bias circuit comprises a first transistor pair comprising a first transistor a second transistor, a second transistor pair comprising a third transistor and a fourth transistor, wherein a source of the first transistor is connected to a drain of the second transistor; wherein a source of the third transistor is connected to a drain of the fourth transistor; wherein a source of the second transistor and a source of the fourth transistor are connected to ground; wherein a drain of the first transistor and a drain of the third transistor are connected to a common node, to which also a current output transistor is connected; wherein the amplified first signal is connected to a gate of the first transistor and a gate of the fourth transistor; wherein the amplified second signal is connected to a gate of the second transistor and a gate of the third transistor; and wherein the current output transistor is configured to output a larger supply current to the comparator when the difference between the amplified first signal and the amplified second signal is smaller, and output a smaller supply current to the comparator when the difference between the amplified first signal and the amplified second signal is larger.

This provides an example of the above-mentioned circuitry of the bump bias circuit. The exemplary bump bias circuit with the various transistors can be integrated with the (transistors of the) comparator, maintaining a low hardware complexity.

In an implementation of the comparator circuit, a source of the current output transistor is connected to a supply voltage; a drain of the current output transistor is connected to the common node; and a gate of the current output transistor is connected to the drain of the current output transistor and to the comparator.

In an implementation of the comparator circuit, the gate of the current output transistor is connected to a gate of a current input transistor of the comparator; wherein the current output transistor and the current input transistor form a current mirror.

In this way, the supply current is mirrored back through the current mirror to the comparator, and can set or transition the comparator into a higher power mode or lower power mode, respectively.

In an implementation of the comparator circuit, the comparator circuit is configured to perform an auto-zeroing operation to calibrate the bump bias circuit, such that the bump bias circuit is configured to cause the comparator to operate at a maximum power level when the amplified first signal is equal to the amplified second signal.

A mismatch across the transistors of the bump bias circuit may introduce an offset, which may shift the zero-crossing point of the feedback signal (e.g., supply current) to the comparator to an offset voltage. To mitigate this effect, the offset calibration - i.e., the auto-zeroing operation - may be performed before the comparator circuit's normal operation. In this way, for example, it may be achieved that the largest supply current is fed back to the comparator, if the amplified first and second signal are equal.

A second aspect of this disclosure provides an ADC circuit for a neural interface, wherein the ADC circuit is configured to receive a differential input signal comprising a first signal and a second signal, and wherein the ADC circuit comprises a first comparator circuit and a second comparator circuit, wherein an inverting input of the first comparator circuit and a non-inverting input of the second comparator circuit are connected to a common mode voltage of the first signal and the second signal, wherein at least one of the first comparator circuit and the second comparator circuit is implemented by a comparator circuit according to the first aspect or any of its implementations; a first switching circuit configured to receive the first signal and to provide a modified first signal via a first voltage line to a non-inverting input of the first comparator circuit; a second switching circuit configured to receive the second signal as an input and to provide a modified second signal via a second voltage line to an inverting input of the second comparator circuit; and a control circuit, wherein an output of each comparator circuit is connected as input to the control circuit; wherein the first switching circuit comprises a plurality of first capacitor pairs, and the second switching circuit comprises a plurality of second capacitor pairs, wherein the first and the second capacitor pairs are respectively arranged one after the other along the first voltage line and the second voltage line, and are respectively connected with a common node to the first voltage line and the second voltage line; wherein the control circuit is configured to set at least one capacitor state of the first capacitor pairs and at least one capacitor state of the second capacitors pairs based on the outputs of the first comparator circuit and the second comparator circuit.

To eliminate usage of voltage thresholds - as required in a conventional LC ADC - a pre-switching concept is introduced, namely by adding the first and the second switching circuit. In particular, these switching circuits may deviate the input signals by a certain voltage value, under the control of the control circuit. The control circuit may be a control DAC. Since no voltage thresholds are needed, additional voltage generators can also be omitted. Further, also an extra on-chip circuit and/or an off-chip fine trimmer for such voltage values are not necessary. Therefore, a hardware complexity of the LC ADC circuit is low.

In the ADC circuit of the second aspect, for example, both the first comparator circuit and the second comparator circuit are integrated with a respective bump bias circuit, as described for the comparator circuit of the first aspect. The differential input signal for the first comparator circuit in this case comprises the modified first signal and the common mode voltage, whereas the differential input signal for the second comparator circuit comprises the common mode voltage and the modified second signal. The first comparator circuit will operate in the higher power mode when the difference between the amplified modified first signal and the amplified common mode voltage is smaller, and the second comparator circuit will operate in the higher power mode when the difference between the amplified modified second signal and the amplified common mode voltage is smaller, wherein signal amplification happens in a respective comparator of the first and second comparator circuit.

One of the first comparator circuit and the second comparator circuit may also be implemented as a simple comparator, such that only one of the first and second comparator circuit is a comparator circuit according to the first aspect. In this case, said comparator circuit does not comprise the bump bias circuit. That being said, integrating both comparator circuits in the same manner is preferred.

The differential input signal maybe a differential voltage signal, i.e., the first signal and the second signal are voltage signals, e.g., of varying voltage value. Also the modified signals and internally amplified signals may be voltage signals.

In an implementation of the ADC circuit, the control circuit is configured to initially set each capacitor state to a default value.

In an implementation of the ADC circuit the control circuit is configured to change at least one capacitor state of the first capacitor pairs, such that a predetermined voltage value is subtracted from the modified first signal when the second signal is smaller than the common mode voltage, and such that the predetermined voltage value is added to the modified first signal when the second signal is larger than the common mode voltage.

In an implementation of the ADC circuit, when the output of the first comparator circuit switches "up" from a low state to a high state, while the output of the second comparator circuit stays at a high state, the control circuit is configured to change at least one capacitor state of the first capacitor pairs such that the predetermined voltage value is subtracted from the modified first signal, and to change at least one capacitor state of the second capacitor pair such that the predetermined voltage value is added to the modified second signal; and when the output of the first comparator circuit switches "down" from a high state to a low state, while the output of the second comparator circuit stays at a low state, the control circuit is configured to change at least one capacitor state of the first capacitor pairs such that the predetermined voltage value is added to the modified first signal, and to change at least one capacitor state of the second capacitor pairs such that the predetermined voltage value is subtracted from the modified second signal.

In an implementation of the ADC circuit, when the output of the second comparator circuit switches "down" from a high state to a low state, the control circuit is configured to change at least one capacitor state of the first capacitor pairs such that twice the predetermined voltage value is added to the modified first signal; and when the output of the second comparator circuit switches "up" from a low state to a high state, the control circuit is configured to change at least one capacitor state of the first capacitor pairs such that twice the predetermined voltage value is subtracted from the modified first signal.

In an implementation of the ADC circuit, the ADC circuit further comprises an up-down counter, which is configured to receive from the control circuit an output signal and an indication of "up" or "down" switch of a comparator circuit output, and is configured to output a cumulated signal based on the output signal and indication received from the control circuit.

A third aspect of this disclosure provides a method of operating a comparator circuit comprising a comparator, the method comprising receiving a differential input signal comprising a first signal and a second signal, and amplifying the first signal and the second signal, respectively, in the comparator; and operating the comparator at a higher power level when a difference between the amplified first signal and the amplified second signal is smaller, and operating the comparator at a lower power level when the difference between the amplified first signal and the amplified second signal is larger.

The method of the third aspect may have implementations that correspond to the implementations of the comparator circuit of the first aspect. The method of the third aspect and its implementations achieve the same advantages a described above with respect to the comparator circuit of the first aspect and its implementation.

BRIEF DESCRIPTION OF THE DRAWINGS

The above described aspects and implementations are explained in the following description of embodiments with respect to the enclosed drawings:

FIG. 1      shows a comparator circuit according to this disclosure.

FIG. 2      shows an exemplary diagram of a comparator circuit according to this disclosure.

FIG. 3      shows a schematic implementation of an exemplary comparator circuit according to this disclosure.

FIG. 4      shows simulation results of respectively an exemplary comparator circuit according to this disclosure and of a conventional comparator.

FIG. 5      illustrates an exemplary comparator offset calibration method.

FIG. 6      shows an ADC circuit according to this disclosure.

FIG. 7      illustrates state machines of main-switching and pre-switching control in an exemplary ADC circuit according to this disclosure.

FIG. 8      shows a neural interface including an array of electrodes, a plurality of recording channels, and an ADC circuit according to this disclosure.

FIG. 9      illustrates transient waveforms of the exemplary ADC circuit according to this disclosure.

FIG. 10     illustrates an exemplary common-mode voltage generation method for an ADC circuit according to this disclosure.

FIG. 11     shows an exemplary M-bit up-down counter of the ADC circuit according to this disclosure.

FIG. 12     shows a method of operating a comparator circuit according to this disclosure.

FIG. 13     shows a conventional LC ADC and some waveforms thereof.

DETAILED DESCRIPTION OF EMBODIMENTS

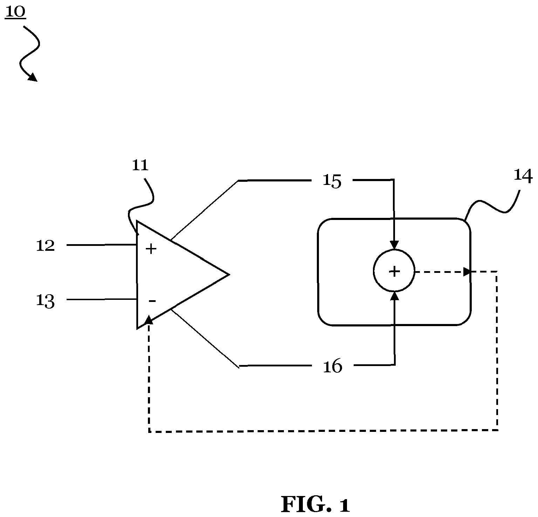

FIG. 1 shows a comparator circuit 10 according to this disclosure. The comparator circuit 10 comprises a comparator 11, which may be a conventional comparator having an inverting and a non-inverting input. The comparator circuit 10 further comprises a bump bias circuit 14. The comparator circuit 10 may thus be referred to as a bump-based adaptive-bias comparator.
The comparator 11 is configured to receive a differential input signal, which comprises a first signal 12 and a second signal 13, for instance, two different voltage signals. At least one of these signals 12, 13 may be time-varying. The comparator 11 is configured to internally amplify the first signal 12 and the second signal 13, respectively, thereby producing an amplified first signal 15 and an amplified second signal 16.
The bump bias circuit 14 is connected to the comparator 11, in particular, such that is configured to receive the amplified first signal 15 and the amplified second signal 16, respectively, from the comparator 11. The bump bias circuit 14 may be configured to determine a difference between the amplified first signal 15 and the amplified second signal 16, for instance, by summing the amplified first signal 15 which is associated with the non-inverting input of the comparator 11 and the amplified second signal 16 which is associated with the inverting input of the comparator 11.
The bump bias 14 circuit is further configured to cause the comparator 11 to operate at a higher power level when a difference between the amplified first signal 15 and the amplified second signal 16 is smaller, and to operate at a lower power level when the difference between the amplified first signal 15 and the amplified second signal 16 is larger. This may be done by providing a feedback signal to the comparator 11 (indicated by dashed arrow), which is dependent on the difference between the amplified first and second signal 15, 16. For instance, the feedback signal may be a supply current. Since the comparator 11 is in this way not always used in the higher power mode, but sometimes in the lower power mode, its power consumption can be lowered. The comparator 11 may only operate in the higher power mode when needed, for instance, in the case of an event expressed by the difference of the amplified signals 15, 16 becoming smaller.

In other words, to reduce the power consumption compared to a conventional comparator, the bump bias circuit 14 is integrated with the comparator 11. The bump bias circuit 14 is used to monitor the intermediate outputs, i.e. the amplified first and second signal 15, 16, which are the amplified versions of the input signals 12, 13 to the comparator 11.

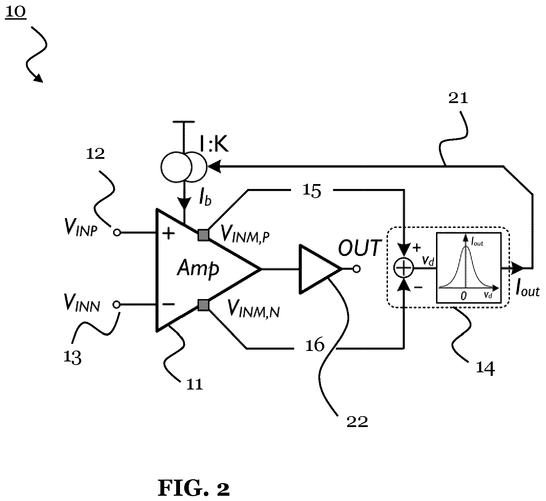

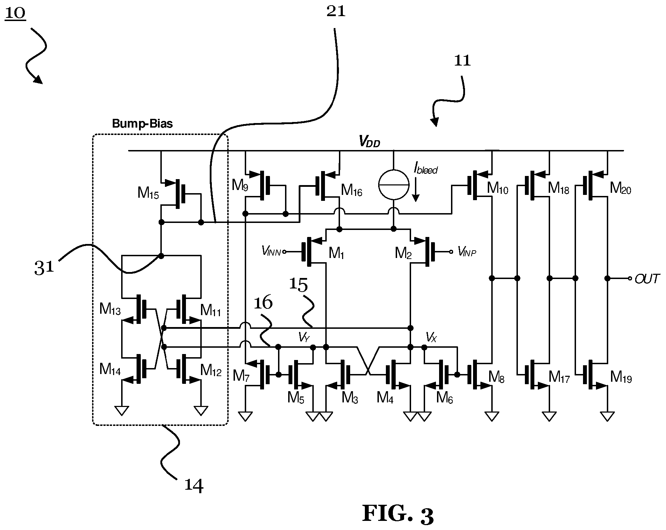

FIG. 2 shows an exemplary diagram of a comparator circuit 10 according to this disclosure, and FIG. 3 shows a schematic implementation of an exemplary comparator circuit 10 according to this disclosure. The comparator circuits 10 of FIG. 2 and 3 respectively base on the comparator circuit 10 of FIG. 1. Same elements are labelled with the same reference signs and may be implemented likewise.

As shown in FIG. 2, the bump bias circuit 14 is in this example configured to provide a supply current as feedback signal to the comparator 11. In particular, the bump bias circuit 14 is configured to provide a larger supply current 21 to the comparator 11 when the difference between the amplified first signal 15 and the amplified second signal 16 is smaller, and is configured to provide a smaller supply current 21 to the comparator 11 when the difference between the amplified first signal 15 and the amplified second signal 16 is larger. Given that the bump bias circuit 14 is calibrated, it may provide the largest supply current 21 to the comparator 11, if the amplified first signal 15 and the amplified second signal 16 are equal.

When the amplified signals 15 and 16 are closer together, the larger supply current will cause the comparator 11 to operate in the higher power mode, e.g., it may transition the comparator 11 into the higher power mode. Conversely, when the amplified signals 15 and 16 differ more from each other, the lower supply current will cause the comparator 11 to operate in the lower power mode, e.g., it may transition the comparator 11 to the lower power mode, in order to significantly save current and power.

Notably, the comparator 11 shown in FIG. 2 may, of course, also proved an output signal 22, like a conventional comparator without bump bias circuit 14.

As shown in FIG. 3, the bump bias circuit 14 may include the four transistors $M_{11}$ to $M_{14}$ and an additional current output transistor $M_{15}$. The transistors $M_{11}$ to $M_{14}$ are incorporated to monitor the intermediate output (amplified signals 15, 16; labelled $V_X$ and $V_Y$) of the comparator 11. $V_X$ and $V_Y$ present the amplified versions of the input signals $V_{INP}$ and $V_{INN}$ shown in FIG. 2. The amplification maybe related to a gain of $g_{m1,2}/(g_{m5,6}-g_{m3,4})$. When the amplified signals 15 and 16 related to the input signals 12 and 13 are close together, the larger supply current 21 is mirrored back through a current mirror to the comparator 11. The current mirror may be formed by $M_{15}$ and a current input transistor $M_{16}$ of the comparator 11. The larger supply current 21 sets the comparator 11 to the higher power mode. The gate of $M_{15}$ is thereby connected to the gate of $M_{16}$. When the amplified signals 15 and 16 related to the input signals 12 and 13 are more different from each other, the smaller supply current sets the comparator 11 to the lower power mode.

In more detail, the first transistor $M_{11}$ and the second transistor $M_{12}$ form a first transistor pair, and the third transistor $M_{13}$ and the fourth transistor $M_{14}$ form a second transistor pair. A source of $M_{11}$ is connected to a drain of $M_{12}$, and a source of $M_{13}$ is connected to a drain of $M_{14}$. Further, a source of $M_{12}$ and a source of $M_{14}$ are connected to ground. A drain of $M_{11}$ and a drain of $M_{13}$ are connected to a common node 31, to which also the current output transistor $M_{15}$ is connected. In particular, a source of $M_{15}$ is connected to a supply voltage $V_{DD}$, a drain of $M_{15}$ is connected to the common node 31, and a gate of $M_{15}$ is connected to the drain of $M_{15}$ and to the comparator 11.

The amplified first signal 15 (Vx) is connected to a gate of $M_{11}$ and to a gate of $M_{14}$, and the amplified second signal 16 ($V_Y$) is connected to a gate of $M_{12}$ and to a gate of $M_{13}$. The current output transistor $M_{15}$ is configured to output a larger supply current 21 to the comparator 11 when the difference between the amplified first signal 15 and the amplified second signal 16 is smaller, and to output a smaller supply current 21 to the comparator 11 when the difference between the amplified first signal 15 and the amplified second signal 16 is larger.

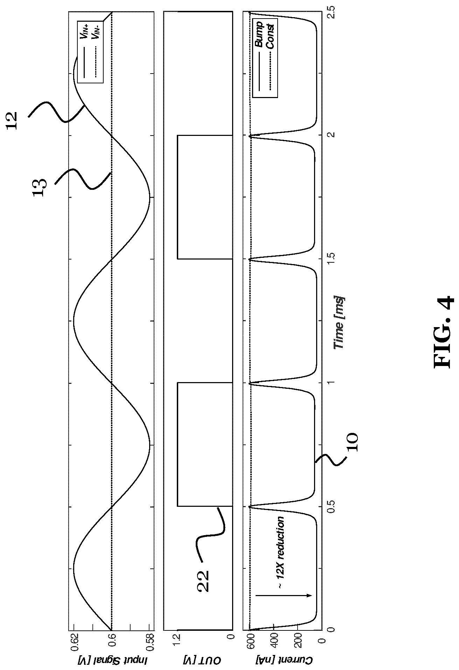

FIG. 4 shows simulation results of the comparator circuit 10, in particular, shows exemplary input (voltage) signals 12 and 13 in the upper diagram, shows an output signal 22 of the comparator in the middle diagram, and shows a current consumption of the comparator 11 - particularly, compared to a conventional constant bias comparator - in the lower diagram. It can be seen that the current consumption, and thus the power consumption, of the comparator 11 is reduced significantly, up to a factor of 12 compared to the conventional comparator.

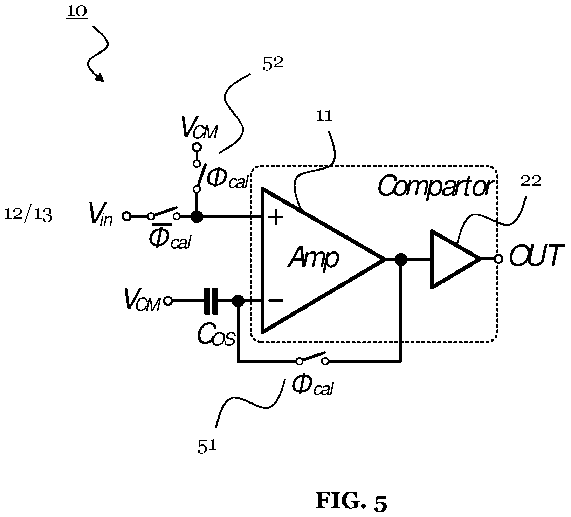

Notably, a mismatch across the transistors of the bump bias circuit 14 could introduce an offset, which could shift the zero-crossing point to an offset voltage Vos. That is, the largest supply current 21 would not be provided for exactly the case when the first amplified signal 15 and the second amplified signal 16 are equal. However, to mitigate this effect, an offset calibration may be performed with the comparator circuit 10, before entering its normal ADC operations. A widely used auto-zeroing technique can be used, as shown in FIG. 5. The auto-zeroing technique may guarantee that largest supply current 21 is provided for the case when the first amplified signal 15 and the second amplified signal 16 are equal.

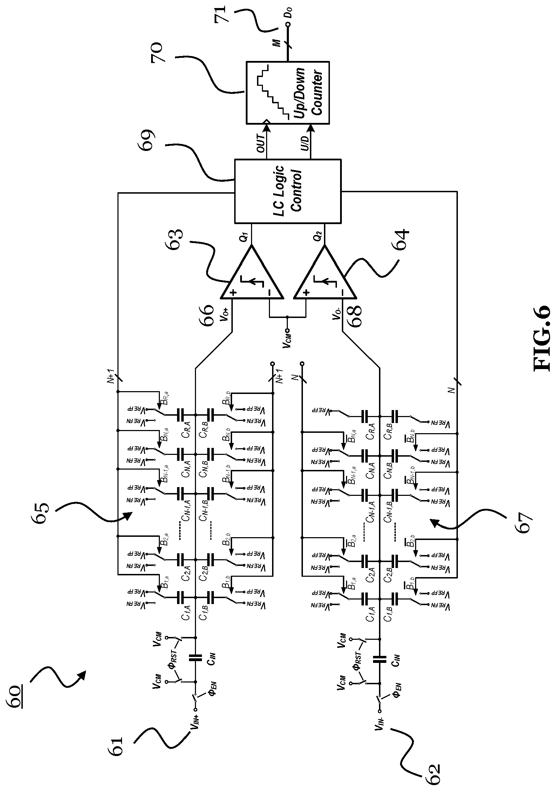

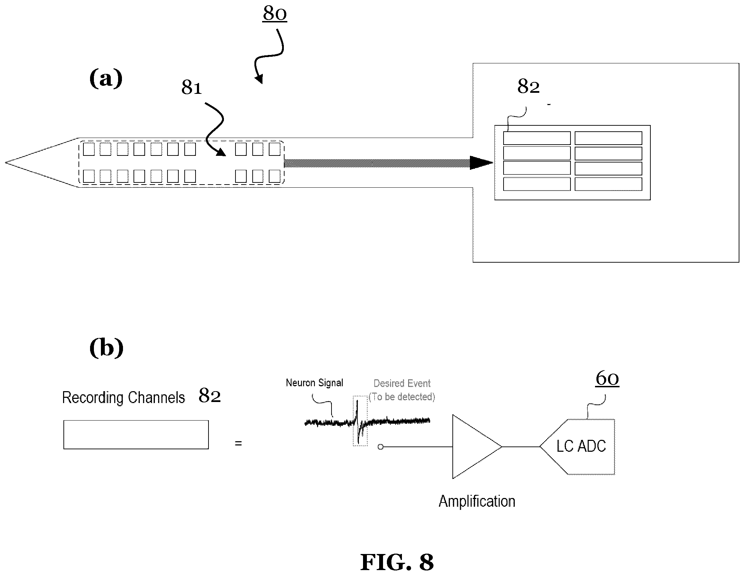

FIG. 6 shows an ADC circuit 60 according to this disclosure. The ADC circuit 60 makes use of the comparator circuit 10 of FIG. 1 or FIG. 2. That is, a beneficial application scenario for the comparator circuit 10 is presented. The ADC circuit 60 may be used for a neural interface 80, as shown in FIG. 8. In particular, in the neural interface 80, the ADC circuit 60 may periodically sample and convert neural signals, for example, for data transmission and post-processing.

FIG. 8(a) shows that the neural interface 80 may comprise a needle-like device, which may be equipped with an array of electrodes 81 connected to a plurality of recording channels 82. The use of the needle-like device may involve implanting the electrodes 82, in order to record or stimulate brain activity. The recording channels 82 can detect electrical signals from neurons of the brain (i.e., the neural signals). Each recording channel 82 may record a particular neural signal, as shown in FIG. 8(b). An event in the neural signal may be detected using the LC based ADC circuit 60 of FIG. 6.

The ADC circuit 60 may accordingly replace a conventional LC ADC, for instance, in a neural interface 80. The ADC circuit 60 comprises a first switching circuit 65 and a second switching circuit 67, which may also be called pre-switching circuits, which are arranged before a first comparator circuit 63 and a second comparator circuit 64 with relation to input and output of the ADC circuit 60. The ADC circuit 60 may thereby be provided with a built-in threshold-window switching mechanism. Either one or both of the first comparator circuit 63 and the second comparator circuit 64 is implemented by a comparator circuit 10 as shown in FIG. 1 or FIG. 2, i.e., it includes a bump bias circuit 14 as explained above.

The first switching circuit 65 and the second switching circuit 67 are used to implement a pre-switching concept in the ADC circuit 60, in order to eliminate the need of voltage thresholds like in a conventional LC ADC.

The first switching circuit 65 is configured to receive a first signal 61, and to output a modified first signal 66 via a first voltage line to a non-inverting input of the first comparator circuit 63. The second switching circuit 67 is configured to receive a second signal 62 as an input, and to provide a modified second signal 68 via a second voltage line to an inverting input of the second comparator circuit 64. An inverting input of the first comparator circuit 63 and a non-inverting input of the second comparator circuit 64 are connected to a common mode voltage VCM of the first signal 61 and the second signal 62. Notably, non-inverting input and inverting input of a comparator circuit 10, 63, 64 relate to a non-inverting input and inverting input of a comparator 11 of said comparator circuit.

If the first comparator circuit 63 and the second comparator circuit 64 are both comparator circuits 10 according to this disclosure, i.e. are both integrated with a respective bump bias circuit 14, as described above, then the differential input signal for the first comparator circuit 63 comprises the modified first signal 66 as the first signal 12, and comprises the common mode voltage as the second signal 13. The differential input signal for the second comparator circuit 64 comprises the modified second signal 68 as the second signal 13, and comprises the common mode voltage as the first signal 12.

The first switching circuit 65 comprises a plurality of first capacitor pairs, and the second switching circuit 67 comprises a plurality of second capacitor pairs ($C_{i,A}$, $C_{i,B}$), wherein the first and the second capacitor pairs are respectively arranged one after the other along the first voltage line and the second voltage line, and are respectively connected with a common node to the first voltage line and the second voltage line.

An output of each comparator circuit 63, 64 (corresponding to the output signal 22 for the comparator circuit 10 shown in FIG. 2) is connected as input to a control circuit 69. The control circuit 69 is configured to set at least one capacitor state of the first capacitor pairs and at least one capacitor state of the second capacitors pairs based on the outputs of the first comparator circuit 63 and the second comparator circuit 64.

The pre-switching concept may be implemented by deviating the first signal 61 and the second signal 62 by a certain predetermined voltage value, which may be controlled by the control circuit 69. For example, by changing at least one capacitor state of the first capacitor pairs, such that a predetermined voltage value is subtracted from the modified first signal 66 when the second signal 62 is smaller than the common mode voltage, and such that the predetermined voltage value is added to the modified first signal 68 when the second signal 62 is larger than the common mode voltage.

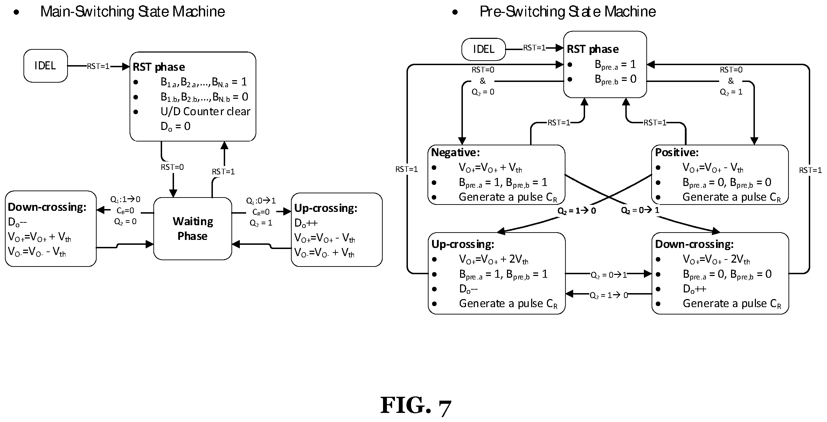

More exemplary details of the ADC circuit 60 are described in the following with reference to FIG. 6 and FIG. 7. For simplicity, it may be assumed that the input signals 61 and 62 ($V_{IN+}$ and $V_{IN-}$) are differential signals with the common-mode voltage $V_{CM}$. As shown in FIG. 6, the ADC circuit 60 may have an M-bit resolution with 2xN identical capacitors ($C_{i,A}$ and $C_{i,B}$, i = 1 ...N) at each switching circuit 65, 67, wherein $N = 2^{(M-1)}-1$. Extra two capacitors $C_{R,A}$ and $C_{R,B}$ may be added for an example of the pre-switching strategy at both switching circuits 65, 67. The input capacitor $C_{in}$ may be equal to the total capacitance of the control circuit 69.

A detailed procedure, which may be performed by the ADC circuit 60, is as follows with reference to FIG. 7, which shows a state machine of main-switching and pre-switching control in an exemplary ADC circuit 60, respectively.

1. At a reset phase, the ADC control logic 69 initiates to a default value where all $B_{1,a}$ ... $B_{N,a}$, $B_{pre,a}$ and $B_{1,b}$ ... $B_{N,b}$, $B_{pre,b}$ bits are set to $(N+1)'b11...11$ and $(N+1)'b00...00,$ respectively. Meanwhile, the differential voltage $V_{O+}$ and $V_{O-}$ at the top plate of the control circuit 69 are set to a common-mode voltage $V_{CM}$. Notably, any of $B_{1,a}$ ... $B_{N,a}$, $B_{pre,a}$ and $B_{1,b}$ ... $B_{N,b}$, when set to 1, is connected to $V_{REFN}$, and when set to 0, is connected to $V_{REFP}$. The same holds for Br,a and Br,b, respectively.

2. After the reset phase, the second comparator circuit 64 will monitor the polarity of the voltage value of $V_{CM}$-$V_{O-}$. If the polarity is *positive ($V_{CM} > V_{O-}$),* the bit $B_{pre,a}$ is changed from 1'b1 to 1'b0. Therefore, the certain value (predetermined

voltage value) $V_{th}$ will be subtracted from Vo+, which equals:

$$V_{th} = VDD \times \frac{C_{R,A}}{C_{in} + \sum_{i=1}^{N} C_{i,A} + \sum_{i=1}^{N} C_{i,B} + C_{R,A} + C_{R,B}} = \frac{VDD}{4N+4}$$

If the polarity is negative ($V_{CM} < V_{O-}$), the bit $B_{pre,b}$ is changed from 1'b0 to 1'b1, and $V_{th}$ will be added to $V_{O+}$.

3. The first comparator circuit 63 continuously monitors the voltage Vo+ and compares it to the common-mode voltage $V_{CM}$.

If an up-crossing ($Q_1$:0→1 while $Q_2=_1$) happens - i.e., when the output of the first comparator circuit 63 switches "up" from a low state to a high state, while the output of the second comparator circuit 64 stays at a high state - the bit $B_{i,a}$ changes from 1'b1 to 1'b0, subtracting the predetermined voltage value $V_{th}$ from the modified first signal Vo+ and adding the predetermined voltage value $V_{th}$ to the modified second signal Vo- respectively.

If a down-crossing ($Q_1$:1→0 while $Q_2=0$) happens - i.e., when the output of the first comparator circuit 63 switches "down" from a high state to a low state, while the output of the second comparator circuit 64 stays at a low state - the bit $B_{i,b}$ changes from 1'b0 to 1'b1, adding the predetermined voltage value $V_{th}$ to the modified first signal Vo+ and subtracting the predetermined voltage value $V_{th}$ from the modified second signal $V_{O-}$ respectively. The output of the ADC is cumulated by $D_0 = D_0 - 1$.

4. The second comparator circuit 64 monitors the voltage Vo- and compares it to the common-mode voltage $V_{CM}$.

If an up-crossing ($Q_2$:1→0) happens - i.e., when the output of the second comparator circuit 64 switches "down" from a high state to a low state - the bit $B_{pre,a}$ and $B_{pre,b}$ both change from 1'b0 to 1'b1, a value of twice the predetermined voltage value 2x$V_{th}$ will be added to the modified first signal Vo+. The output of the ADC is cumulated by $D_0 = D_0 - 1$.

If a down-crossing ($Q_2$:0→1) happens - i.e., when the output of the second comparator circuit 64 switches "up" from a low state to a high state - the bit $B_{pre,a}$ and $B_{pre,b}$ both change from 1'b1 to 1'b0, a value of twice the predetermined voltage value 2x$V_{th}$ will be subtracted from the modified first signal Vo+. The output of the ADC is cumulated by $D_0 = D_0 + 1$.

5. The steps 2 to 4 will be repeated until a reset is activated or the output of the ADC circuit 60 is overflowed.

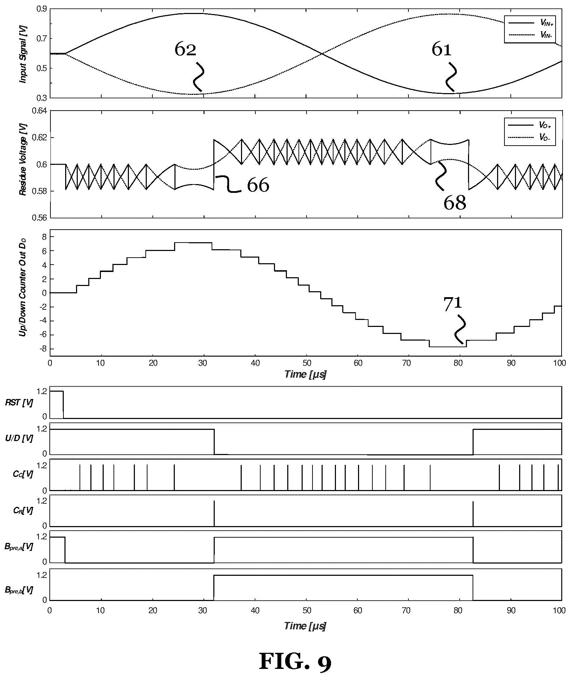

FIG. 9 shows some transient waveforms of the exemplary ADC circuit 60 according to this disclosure. In particular, the upper diagram shows the first and second signal 61, 62, while the second diagram shows the modified signals 66, 68. The output 71 provided by the up-down counter 70 is shown in the next diagram, and the bottom diagram illustrates some internal parameters of the ADC circuit 60.

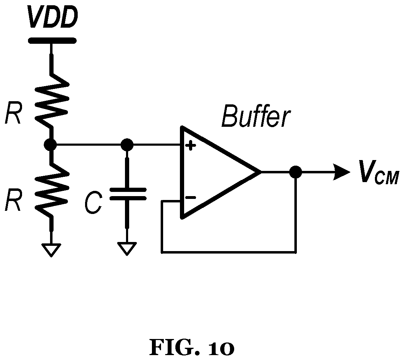

As further shown in FIG. 10, the common-mode voltage $V_{CM}$ can be generated globally with a division ratio of 0.5 from the supply voltage $V_{DD}$ by a resistive divider. Notice that unlike the threshold voltage $V_H$ and $V_L$ in a conventional LC ADC, the common-mode voltage $V_{CM}$ can be shared across recording channels and the ADC circuit 60. The noise of the $V_{CM}$ can be filtered out by a simple RC filter to minimize its impact on the comparator decision.

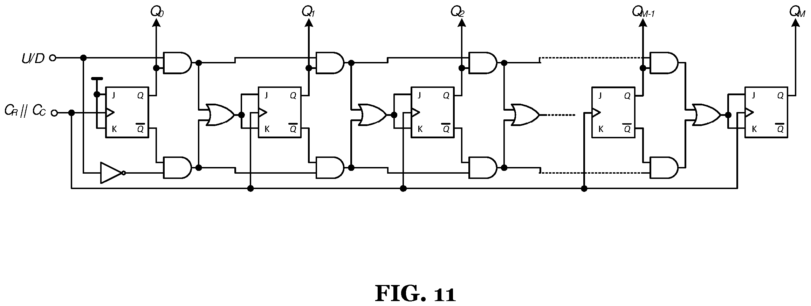

As further shown in FIG. 11, the (M-bit) up-down counter 70 of the ADC circuit 60 can be implemented using multiple JK flip-flops.

FIG. 12 shows a method 100 of operating a comparator circuit 10 according to this disclosure, wherein the comparator circuit comprises a comparator 11, and may be the comparator circuit 10 of FIG. 1 or FIG. 2. The comparator circuit 10 may accordingly comprise the bump bias circuit 14. The method 100 comprises a step 101 of receiving a differential input signal comprising the first signal 12 and the second signal 13, and of amplifying the first signal 12 and the second signal 13, respectively, in the comparator 11. The method 100 further comprises a step 102 of operating the comparator 11 at the higher power level when a difference between the amplified first signal 15 and the amplified second signal 16 is smaller, and comprises a step 103 of operating 103 the comparator at the lower power level when the difference between the amplified first signal 15 and the amplified second signal 16 is larger. The steps 102 and 103 may be performed by the bump bias circuit 14, causing the comparator 11 to operate in the respective power mode.

In summary of the above, the solutions provided in this disclosure can eliminate the use of the external threshold voltages $V_H$ and $V_L$ as required in a conventional LC ADC. This can be achieved by the ADC circuit 60 using the control circuit 69 to generate the threshold window, hence, avoiding the mismatch between the threshold and feedback value $V_{th}$.

Moreover, the bump-based adaptive-bias comparator circuit 10 can efficiently reduce a power consumption compared to the conventional continuous-time comparator. This is, because it consumes power only when the differential input is close to each other.

The solutions of this disclosure can be applied within high-density neural recording systems, particularly for data compression, resulting in a substantial reduction in data throughput requirements for high-density neural probes (e.g., Neuropixels 1.0, 2.0 and NXT).

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A comparator circuit (10) comprising

   a comparator (11) configured to receive a differential input signal comprising a first signal (12) and a second signal (13), and configured to internally amplify the first signal (12) and the second signal (13), respectively;
   a bump bias circuit (14) configured to receive the amplified first signal (15) and the amplified second signal (16);
   wherein the bump bias (14) circuit is further configured to cause the comparator (11) to
   operate at a higher power level when a difference between the amplified first signal (15) and the amplified second signal (16) is smaller, and
   operate at a lower power level when the difference between the amplified first signal (15) and the amplified second signal (16) is larger.

2. The comparator circuit (10) according to claim 1, wherein the bump bias circuit (14) is configured to

   provide a larger supply current (21) to the comparator (11) when the difference between the amplified first signal (15) and the amplified second signal (16) is smaller; and
   provide a smaller supply current (21) to the comparator (11) when the difference between the amplified first signal (15) and the amplified second signal (16) is larger.

3. The comparator circuit (10) according to claim 1 or 2, wherein the bump bias circuit (14) is configured to provide a continuously increasing supply current (21) to the comparator (11) when a difference between the amplified first signal (15) and the amplified second signal (16) continuously decreases.

4. The comparator circuit (10) according to one of the claims 1 to 3, wherein the bump bias circuit (14) comprises

   a first transistor pair comprising a first transistor ($M_{11}$) a second transistor ($M_{12}$),
   a second transistor pair comprising a third transistor ($M_{13}$) and a fourth transistor ($M_{14}$),
   wherein a source of the first transistor ($M_{11}$) is connected to a drain of the second transistor ($M_{12}$);
   wherein a source of the third transistor ($M_{13}$) is connected to a drain of the fourth transistor ($M_{14}$);
   wherein a source of the second transistor ($M_{12}$) and a source of the fourth transistor ($M_{14}$) are connected to ground;
   wherein a drain of the first transistor ($M_{11}$) and a drain of the third transistor ($M_{13}$) are connected to a common node (31), to which also a current output transistor ($M_{15}$) is connected;
   wherein the amplified first signal (15) is connected to a gate of the first transistor ($M_{11}$) and a gate of the fourth transistor ($M_{14}$);
   wherein the amplified second signal (16) is connected to a gate of the second transistor ($M_{12}$) and a gate of the third transistor ($M_{13}$); and
   wherein the current output transistor ($M_{15}$) is configured to output a larger supply current (21) to the comparator (11) when the difference between the amplified first signal (15) and the amplified second signal (16) is smaller, and output a smaller supply current (21) to the comparator (11) when the difference between the amplified first signal (15) and the amplified second signal (16) is larger.

5. The comparator circuit (10) according to claim 4, wherein

a source of the current output transistor ($M_{15}$) is connected to a supply voltage;
a drain of the current output transistor ($M_{15}$) is connected to the common node (31); and
a gate of the current output transistor ($M_{15}$) is connected to the drain of the current output transistor ($M_{15}$) and to the comparator (11).

6. The comparator circuit (10) according to claim 4 or 5, wherein

the gate of the current output transistor ($M_{15}$) is connected to a gate of a current input transistor ($M_{16}$) of the comparator (11);
wherein the current output transistor ($M_{15}$) and the current input transistor ($M_{16}$) form a current mirror.

7. The comparator circuit (10) according to one of the claims 1 to 6, configured to
perform an auto-zeroing operation to calibrate the bump bias circuit (14), such that the bump bias circuit (14) is configured to cause the comparator (11) to operate at a maximum power level when the amplified first signal (15) is equal to the amplified second signal (16).

8. An analog to digital converter, ADC, circuit (60) for a neural interface, wherein the ADC circuit (60) is configured to receive a differential input signal comprising a first signal (61) and a second signal (62), and wherein the ADC circuit (60) comprises

a first comparator circuit (63) and a second comparator circuit (64), wherein an inverting input of the first comparator circuit (63) and a non-inverting input of the second comparator circuit (64) are connected to a common mode voltage of the first signal (61) and the second signal (62), wherein at least one of the first comparator circuit (63) and the second comparator circuit (64) is implemented by a comparator circuit (10) according to one of the claims 1 to 7;
a first switching circuit (65) configured to receive the first signal (61) and to provide a modified first signal (66) via a first voltage line to a non-inverting input of the first comparator circuit (63);
a second switching circuit (67) configured to receive the second signal (62) as an input and to provide a modified second signal (68) via a second voltage line to an inverting input of the second comparator circuit (64); and
a control circuit (69), wherein an output of each comparator circuit (63, 64) is connected as input to the control circuit (69);
wherein the first switching circuit (65) comprises a plurality of first capacitor pairs, and the second switching circuit (67) comprises a plurality of second capacitor pairs, wherein the first and the second capacitor pairs are respectively arranged one after the other along the first voltage line and the second voltage line, and are respectively connected with a common node to the first voltage line and the second voltage line;
wherein the control circuit (69) is configured to set at least one capacitor state of the first capacitor pairs and at least one capacitor state of the second capacitors pairs based on the outputs of the first comparator circuit (63) and the second comparator circuit (64).

9. The ADC circuit (60) according to claim 8, wherein the control circuit (69) is configured to initially set each capacitor state to a default value.

10. The ADC circuit (60) according to claim 8 or 9, wherein the control circuit (69) is configured to
change at least one capacitor state of the first capacitor pairs, such that a predetermined voltage value is subtracted from the modified first signal (66) when the second signal (62) is smaller than the common mode voltage, and such that the predetermined voltage value is added to the modified first signal (68) when the second signal (62) is larger than the common mode voltage.

11. The ADC circuit (60) according to claim 10, wherein

when the output of the first comparator circuit (63) switches "up" from a low state to a high state, while the output of the second comparator circuit (64) stays at a high state, the control circuit (69) is configured to change at least one capacitor state of the first capacitor pairs such that the predetermined voltage value is subtracted from the modified first signal (66), and to change at least one capacitor state of the second capacitor pair such that the predetermined voltage value is added to the modified second signal (68); and
when the output of the first comparator circuit (63) switches "down" from a high state to a low state, while the output of the second comparator circuit (64) stays at a low state, the control circuit (69) is configured to change at least one capacitor state of the first capacitor pairs such that the predetermined voltage value is added to the modified first signal (66), and to change at least one capacitor state of the second capacitor pairs such that the predetermined voltage value is subtracted from the modified second signal (68).

12. The ADC circuit (60) according to claim 10 or 11, wherein

when the output of the second comparator circuit (64) switches "down" from a high state to a low state, the control circuit (69) is configured to change at least one capacitor state of the first capacitor pairs such that twice the predetermined voltage value is added to the modified first signal (66); and
when the output of the second comparator circuit (64) switches "up" from a low state to a high state, the control circuit (69) is configured to change at least one capacitor state of the first capacitor pairs such that twice the predetermined voltage value is subtracted from the modified first signal (66).

13. The ADC circuit (60) according to claim 11 or 12, further comprising
an up-down counter (70), which is configured to receive from the control circuit (69) an output signal and an indication of "up" or "down" switch of a comparator circuit output, and is configured to output a cumulated signal (71) based on the output signal and indication received from the control circuit (69).

14. A method (100) of operating a comparator circuit (10) comprising a comparator (11), the method (100) comprising

receiving (101) a differential input signal comprising a first signal (12) and a second signal (13), and amplifying the first signal (12) and the second signal (13), respectively, in the comparator (11); and
operating (102) the comparator (11) at a higher power level when a difference between the amplified first signal (15) and the amplified second signal (16) is smaller, and
operating (103) the comparator at a lower power level when the difference between the amplified first signal (15) and the amplified second signal (16) is larger.

FIG. 1

FIG. 2

FIG. 3

FIG. 4

FIG. 5

EP 4 730 654 A1

**FIG.6**

EP 4 730 654 A1

- Main-Switching State Machine

- Pre-Switching State Machine

IDEL —RST=1→ **RST phase**
- $B_{1.a}, B_{2.a}, ..., B_{N.a} = 1$
- $B_{1.b}, B_{2.b}, ..., B_{N.b} = 0$
- U/D Counter clear
- $D_o = 0$

RST=0 ↓     ↑ RST=1

**Down-crossing:**
$D_o--$
$V_{O+}=V_{O+} + V_{th}$
$V_{O-}=V_{O-} - V_{th}$

← $Q_1:1→0$ / $C_R=0$ / $Q_2=0$ —

**Waiting Phase**

— $Q_1:0→1$ / $C_R=0$ / $Q_2=1$ →

**Up-crossing:**
$D_o++$
$V_{O+}=V_{O+} - V_{th}$
$V_{O-}=V_{O-} + V_{th}$

IDEL —RST=1→ **RST phase**
- $B_{pre.a} = 1$
- $B_{pre.b} = 0$

RST=0 & $Q_2 = 0$

RST=0 & $Q_2 = 1$

RST=1     RST=1

**Negative:**
- $V_{O+}=V_{O+} + V_{th}$
- $B_{pre.a} = 1, B_{pre.b} = 1$
- Generate a pulse $C_R$

**Positive:**
- $V_{O+}=V_{O+} - V_{th}$
- $B_{pre.a} = 0, B_{pre.b} = 0$
- Generate a pulse $C_R$

$Q_2 = 1→0$     $Q_2 = 0→1$

**Up-crossing:**
- $V_{O+}=V_{O+} + 2V_{th}$
- $B_{pre.a} = 1, B_{pre.b} = 1$
- $D_o--$
- Generate a pulse $C_R$

— $Q_2 = 0→1$ →
← $Q_2 = 1→0$ —

**Down-crossing:**
- $V_{O+}=V_{O+} - 2V_{th}$
- $B_{pre.a} = 0, B_{pre.b} = 0$
- $D_o++$
- Generate a pulse $C_R$

RST=1     RST=1

**FIG. 7**

(a)

80

81

82

(b)

Recording Channels 82 =

Neuron Signal

Desired Event
(To be detected)

Amplification

LC ADC

60

FIG. 8

**FIG. 9**

FIG. 10

**FIG. 11**

100

101 → receive a differential input signal comprising a first signal and a second signal, and amplify the first signal and the second signal, respectively in a comparator

102 → operate the comparator at a higher power level when the difference between the amplified first signal and the amplified second signal is smaller

103 → operate the comparator at a lower power level when the difference between the amplified first signal and the amplified second signal is larger

**FIG. 12**

EP 4 730 654 A1

**(a)**

**(b)**

FIG. 13

Europäisches
Patentamt

European
Patent Office

Office européen
des brevets

# EUROPEAN SEARCH REPORT

**Application Number**

EP 24 20 6830

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/184927 A1 (AKITA SHIN-ICHI [JP]) 2 October 2003 (2003-10-02) * paragraphs [0043] - [0047], [0063]; figure 17 * | 1-3,7,14 | INV. H03M1/06 H03F3/45 H03K5/24 H03M1/12 |
| X | US 9 608 614 B2 (SONY CORP [JP]; SONY SEMICONDUCTOR SOLUTIONS CORP [JP]) 28 March 2017 (2017-03-28) * figures 9,10 * | 1,14 | H03M1/46 H03M1/80 |
| A | US 2013/194039 A1 (HIROSE TETSUYA [JP] ET AL) 1 August 2013 (2013-08-01) * figures 1-4, 7 * * paragraphs [0072] - [0079], [0085] - [0085], [0095]; figures 3,6a,8 * | 4-6 | |

**TECHNICAL FIELDS SEARCHED (IPC)**

H03M
H03F
H03K

The present search report has been drawn up for all claims

| Place of search | Date of completion of the search | Examiner |
|---|---|---|
| The Hague | 11 March 2025 | Galardi, Leonardo |

EPO FORM 1503 03.82 (P4C01)

Europäisches
Patentamt

European
Patent Office

Office européen
des brevets

**Application Number**

EP 24 20 6830

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-7, 14

☐ The present supplementary European search report has been drawn up for those parts of the European patent application which relate to the invention first mentioned in the claims (Rule 164 (1) EPC).

Europäisches
Patentamt
European
Patent Office
Office européen
des brevets

**LACK OF UNITY OF INVENTION**

**SHEET B**

The Search Division considers that the present European patent application does not comply with the requirements of unity of invention and relates to several inventions or groups of inventions, namely:

     1. claims: 1-7, 14

        A comparator circuit comprising a bump bias circuit
             ---

     2. claims: 8-13

        A level crossing ADC without voltage thresholds, using a comparator circuit with a bump bias circuit.
             ---

## ANNEX TO THE EUROPEAN SEARCH REPORT
## ON EUROPEAN PATENT APPLICATION NO.

EP 24 20 6830

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2025

| Patent document cited in search report | | | Publication date | Patent family member(s) | | Publication date |
|---|---|---|---|---|---|---|
| US 2003184927 | A1 | | 02-10-2003 | JP 2002311063 A | | 23-10-2002 |
| | | | | US 2003184927 A1 | | 02-10-2003 |
| US 9608614 | B2 | | 28-03-2017 | CN 104753505 A | | 01-07-2015 |
| | | | | CN 110022139 A | | 16-07-2019 |
| | | | | JP 6180318 B2 | | 16-08-2017 |
| | | | | JP 2015126454 A | | 06-07-2015 |
| | | | | US 2015187335 A1 | | 02-07-2015 |
| | | | | US 2017163253 A1 | | 08-06-2017 |
| US 2013194039 | A1 | | 01-08-2013 | JP 5503671 B2 | | 28-05-2014 |
| | | | | JP 2013157805 A | | 15-08-2013 |
| | | | | US 2013194039 A1 | | 01-08-2013 |

EPO FORM P0459

For more details about this annex : see Official Journal of the European Patent Office, No. 12/82